# EUROPEAN PATENT SPECIFICATION

(11) **EP 3 969 888 B1**
(45) Date of publication and mention of the grant of the patent: **24.07.2024**
(21) Application number: 20725459.0
(22) Date of filing: 06.05.2020
(51) Int. Cl.: G01N 27/12, H01L 21/67, C23C 16/56

(54) **PHOTO-ANNEALING IN METAL OXIDE SENSORS**
FOTO-GLÜHEN IN METALLOXID-SENSOREN
LE PHOTO-RECUIT DANS LES CAPTEURS À OXYDE MÉTALLIQUE

(30) Priority: 16.05.2019 US 201916414127
(43) Date of publication of application: 23.03.2022
(73) Proprietor: Sciosense B.V., 5656 AE Eindhoven (NL)
(72) Inventor: ZULIANI, Claudio, Harlow, Essex CM19 4BE (GB)
(74) Representative: Epping - Hermann - Fischer
(86) International application number: PCT/EP2020/062576
(87) International publication number: WO 2020/229263

(56) References cited:
- KR-A- 20180 019 798
- KR-A- 20180 063 471
- US-A1- 2019 041 346
- STEINER K ET AL: "Laser annealing of SnO"2 thin-film gas sensors in single chip packages", SENSORS AND ACTUATORS B: CHEMICAL, ELSEVIER BV, NL, vol. 26, no. 1-3, 2 January 1995 (1995-01-02), pages 64 - 67, XP027261086, ISSN: 0925-4005, [retrieved on 19950101]
- CHUN-CHING HSIAO ET AL: "A Rapid Process for Fabricating Gas Sensors", SENSORS, vol. 14, no. 7, 9 July 2014 (2014-07-09), pages 12219 - 12232, XP055724115, DOI: 10.3390/s140712219

## Description

### Field

This disclosure relates to the annealing of metal oxide films in environmental sensors.

### Background

Metal oxide (MOX) sensors are a well-established technology and are based on the deposition of a metal oxide film onto sensing electrodes defined on or within a suitable substrate. The substrate could be a ceramic or a silicon substrate. The deposition process could use a thin film technology, such as sputtering, atomic layer deposition or chemical vapour deposition, or a thick film technology such as screen printing, drop coating or ink jetting. In the latter case, a precursor to the film could be deposited in the form of an ink or paste where metal oxide grains are held in suspension in a suitable agent, often comprising of organic solvents and additives. This suspension agent generally needs to be decomposed or driven off the precursor, including any organic compounds decomposed to leave an uncontaminated metal oxide. Furthermore, the metal oxide generally needs to be fired/annealed/sintered to form a structure which is mechanically robust and stable, which adheres to the substrate and the sensing electrodes. The above process has an impact in controlling the porosity of the resulting metal oxide film which in turns impact on the sensors characteristics such as sensitivity and selectivity.

The drying and organic decomposition processes generally require temperatures up to around 300-400°C but the firing process requires much higher temperatures. These temperatures are dependent on many variables such as the chemical and physical properties of the metal oxide material, the size and concentration of the metal dopants added to the bulk metal oxide, the metal oxide grain size, the film thickness, and the required final structure and porosity. Generally these temperatures exceed 500 °C, and may even be sustained at temperatures above 1000 °C. As such, in typical annealing, there is a risk of adversely affecting the quality of materials in the sensor such as the substrate, the sensing electrodes and any interconnects.

Certain materials may be susceptible to degradation, or may become molten, at very high temperatures. For example, the substrate may comprise Aluminium which may only be safely heated to around 380 °C, above which temperature the integrity of the substrate may be adversely affected. For example, CMOS wire-bond pads are generally Aluminium which will readily degrade (e.g., oxidation and/or melting) at temperatures greater than about 400 °C which renders them unsuitable for wire-bonding or providing an Ohmic interconnect. Another example is the structure of the Interdigitated Electrodes, which allow measurement of the MOX film resistance. The metal stack is also susceptible to degradation (e.g., interdiffusion of metal layers and/or melting) at elevated temperatures.

Typical annealing processes using standard conduction and/or convection ovens may thus compromise the final quality of the substrate and any circuits or interconnects contained therein. If the entire sensor is placed in an oven for annealing, it will be understood that the all components must be in thermal equilibrium. This presents limitation upon the annealing temperature if sensitive metals, such as Aluminium, are present in the substrate. Nevertheless, some metal oxides may require very high temperatures to be annealed and it is not possible to incorporate such materials in the gas sensors.

Alternative measures may be also suitable to mitigate for a very high (e.g. > 1000 ° C) annealing temperature in a typical annealing setup such as: active cooling on the substrate; or fabrication of the sensor substrate using materials more thermally resistant but expensive, materials such as platinum; or by doing an in-situ electrical annealing by using the embedded microheater which, however, adds a considerable production cost and time. Alternatively, sources of heat such as infrared lamps may be employed thus to produce a thermal gradient across the different substrate portions leveraging on the different thermal properties of the device. However, absorption of infrared radiation by metal oxide may be inefficient, thus annealing by IR-lamps affords an ineffective method.

Document US 2019/0041346 A1 describes a sensing layer formation and explains a method for heating a gas sensor material formulation on a micro hotplate structure with infrared radiation. An infrared heater generates an initial temperature, for example about 300 °C. This is then followed by a ramp to a higher temperature, for example about 600 °C, which forms a stable porous sensing structure. The sensing structure may comprise a metal oxide material or a combination of metal oxides.

Document KR 2018-0063471 A refers to a gas sensor with a two-dimensional porous metal oxide nano-sheet and a manufacturing method. The sensor comprises a plastic substrate and a metal oxide nano-sheet with a two-dimensional plate-shaped structure formed on the plastic substrate. The metal oxide nano-sheet comprises a plurality of nano-pores formed by a light sintering process.

Document KR 2018-0019798 A describes a gas sensor and a manufacturing method. The gas sensor includes a three dimensional nano-layer structured metal oxide, having a particle which is grown as a single crystal through an optical sintering.

The publication "Laser annealing of SnO2 thin-film gas sensors in single chip packages", K. Steiner et al., Sensors and Actuators B, Vol. 26-27, p. 64-67, 1995 is related to a thin-film gas sensor using SnO₂ as metal oxide. Laser annealing is performed with an Nd:YAG laser.

The publication "A rapid process for fabricating gas sensors", C. Hsiao et al., Sensors, Vol 14, p. 12219-12232, 2014 refers to CO gas sensor using zinc oxide, ZnO. A porous ZnO film deposited by a rapid process of aerosol deposition is employed as the gas-sensitive material. The fabrication method uses laser annealing.

It is an object to provide a method of annealing a composition to produce a film for a sensing device.

### Summary

The object is achieved by the method of the independent claim. Further developments are described in the dependent claims.

According to one aspect of the disclosure, there is provided a method of annealing a composition to produce a film for a sensing device, which is defined by claim 1, wherein the composition comprises at least a first metal oxide material and a second metal oxide material. The method comprises: depositing the composition on one side of a substrate; providing a source of electromagnetic radiation in a proximity to the composition; exposing a surface of the composition to a first dose of electromagnetic radiation, wherein the first dose comprises a first property which induces annealing of the composition; and exposing the surface of the composition to a second dose of electromagnetic radiation, wherein the second dose comprises a second property which induces annealing of the composition. The first property is substantially the same or different to the second property.

Said first property may differ from said second property in terms of any of: a wavelength bandwidth, a pulse duration, and a duty cycle (on/off ratio for the source of electromagnetic radiation). A third, and even fourth, dose of radiation may also be exposed to the surface, e.g. to induce annealing in a third and fourth aspect of the device. As such, the method may generally comprise an arbitrary number of doses, corresponding to an arbitrary number of metal oxide materials present in the composition.

Accordingly, it will be understood that either or both of the first and second doses may be delivered in packets or as a plurality short pulses, wherein the pulses may be interspersed with a plurality of non-exposure intervals. In other words, each of the first and second doses may be a pulse envelope of radiation. Advantageously, the first property may be chosen such that only a first aspect of the composition, such as a first metal oxide, is annealed by the first dose. This may also apply mutatis mutandis for the second dose.

As a result of the first and second doses of electromagnetic radiation, the resultant film may comprise a structure porous to gas. Advantageously, either or both of the first and second properties, and/or a cycle of pulses used, may be tailored to tune the porosity of the resultant film, i.e. to control diffusion within the pores which in turn results in control of gas sensitivity and selectivity.

The electromagnetic radiation of the first and second doses may comprise electromagnetic radiation in a range of any of: UV, visible, near infra-red, and far infra-red. That is, the first and second doses may have associated frequencies, or associated frequency ranges, in any of the above spectra e.g. the UV-Vis spectrum range. Such ranges of the electromagnetic spectrum may thus be tuned in order to be absorbed most efficiently by the at least one metal oxide present in the composition.

Furthermore, either or both of the first and second properties may be chosen such that the frequencies of electromagnetic radiation complement an absorption spectrum of the at least one metal oxide, which may include matching spectral absorption characteristics of a metal oxide material with a wavelength of radiation band emitted by the source of electromagnetic radiation. Advantageously, by maximising an overlap between an intensity of a particular frequency in the radiation source and an absorption maximum in the absorption spectrum of a metal oxide, a highly efficient heating of the composition may be effected. In turn, this bears the advantage that the metal oxides may be annealed rapidly, and where it is possible to heat the surface of the composition to high temperatures rapidly.

Further advantageously, because the doses of radiation may be provided in relatively very short pulses, the temperature of the system will relax to environmental condition in a very short transient time. Thus, using light in the UV to visible range, e.g. as provided by xenon lamps, allows a rapid annealing of the composition without causing damage to other parts of the substrates. For example, potential damage to aluminium pads is mitigated, since the high temperature possibly reached during the short pulse time of the annealing is followed by rapid thermal relaxation to environmental conditions. This is in stark contrast with, for example, an oven annealing which may require a high temperature to be sustained over several hours.

The first and second properties of the first and second doses may also relate to lengths of exposure time. Relatively short individual exposure times of around 0.2 ms may be used, given the potential to efficiently irradiate the surface of the MOX composition by maximising the overlap between the spectrum of the radiation in the source and the absorption spectrum of the metal oxide. Therefore, advantageously, even if the composition or surface is heated to a high temperature, the heat transfer occurs rapidly and may thus dissipate very quickly. Thus, heat dissipation into the underlying substrate, which may comprise components sensitive to temperature, e.g., contact pads and interdigitated electrodes, can be mitigated. Furthermore, the need to have active cooling in the substrate can be mitigated as a result of the rapid heating of the composition.

At least one of the first and second properties of the first and second doses may further be chosen to functionalise an aspect of chemistry of the composition, and/or the electronic energy band, which may include enhancing additive decomposition and modulating the density of the charge carriers within the metal oxide.

For example, a spectrum in the UV range may be chosen for either or both of the first and second exposures, whereby the UV radiation may change the surface chemistry of the composition. For example, hydroxyl groups may be included during such a functionalisation step which impacts for instance surface wettability and overall film conductivity. In addition, UV radiation may impact on energy band characteristics of the metal oxide such as the density of bulk carriers which in turns affects the gas sensitivity of the resulting devices. The above photo-annealing may also produce photo-generated holes which may enhance further the degradation of the organic additives, i.e., combining thermal and redox mechanism.

The composition comprises a first metal oxide material and a second metal oxide material, wherein the first and second metal oxide materials possess different first and second absorption spectra. Furthermore, the method comprises choosing the first and second absorption spectra of the first and second doses of radiation to complement the absorption spectra of the first and second metal oxide materials. As such, the property of the first dose is tuned such that it efficiently transfers energy, and thus efficiently anneals, only the first metal oxide. The same holds true, mutatis mutandis, for the second dose and second metal oxide.

As such, the method further includes that the first dose of radiation induces a rate of annealing in the first metal oxide which is higher relative to a rate of annealing induced in the second metal oxide by the first dose, and wherein the second dose of radiation induces a rate of annealing in the second metal oxide which is higher relative to a rate of annealing induced in the first metal oxide by the second dose.

In effect, this means that: the higher rate of annealing in the first metal oxides may correspond to a higher temperature only in a local region of the first metal oxide material; and the higher rate of annealing in the second metal oxides may correspond to a higher temperature only in a local region of the second metal oxide material. Regions containing the first and second surfaces metal oxides may also be separated such that they are in separate regions, or separate deposits, of the composition.

An area of the surface of composition exposed may be the same between the first and second doses of radiation. That is, both of the first and second doses of radiation may uniformly irradiate the surface of the composition, independent of the associated frequency, exposure length, or pulse cycle of either dose.

Alternatively, the surface of the composition may comprise a first region and a second region, wherein the first and second regions are separated.

Furthermore, in the scenario with separate first and second regions, during exposing the surface of the composition to the first dose of electromagnetic radiation, a first mask may be provided before the source of electromagnetic radiation, wherein the first mask may allow transmission of radiation to the first region of the composition. That is, the mask may be opaque such that it does not transmit light to the second region.

Similarly, during exposing the surface of the composition to the second dose of electromagnetic radiation, a second mask may be provided before the source of electromagnetic radiation, wherein the second mask allows transmission of radiation to the second region of the composition. That is, the mask may be opaque such that it does not transmit light to the first region during the second dose exposure.

The method of claim 1, further comprising providing either or both of the first dose and second dose of radiation in a plurality of pulses, wherein the pulses are interspersed with intervals of non-exposure.

Exposing the surface of the composition to either or both of the first and second doses may cause the composition to reach a temperature between 400 and 1500 ° C.

For example, the heat imparted to the composition, and thus the temperature reached, may be modulated by altering the frequency of the radiation, and/or the length of duration of the exposure. For example, increased temperature of the composition during the exposing of the surface of the composition may be achieved by any of: increasing a frequency of the electromagnetic radiation; maximising an overlap between an intensity of a particular frequency in the radiation source and an absorption maximum in the absorption spectrum of a metal oxide; and increasing a length of time of exposure.

The total exposure time may be less than about 10 ms, and more generally may be less than about 1 - 100 ms. For example; this may include having a series of a plurality of pulses of between 0.2 ms - 1 ms, interspersed with intervals of non-exposure.

The composition may further comprise a polymer, which may a polymer additive to control its rheological properties, wherein either or both of the first and second dose may causes decomposition, e.g. combustion, of the polymer to gaseous by-products. The gases produced by such a composition may comprise CO₂ and H₂O. Furthermore, the rate of production of such gases may contribute to the porosity of the internal structure of the resultant film produced by photo-irradiation of the composition containing metal oxide.

The method may further comprise providing a second source of electromagnetic radiation in a proximity to the composition, wherein the second source provides the second dose of electromagnetic radiation having the associated second property. That is, each of the first and second doses may be provided by separate sources such separate lamps, where each lamp may be designed to produce a light source in different ranges of the electromagnetic spectrum.

According to another aspect of the disclosure, there is provided method of manufacturing a sensing device, wherein the sensing device comprises a film comprising at least one metal oxide. The method comprises: providing a precursor composition comprising at least one metal oxide and an organic additive; depositing the precursor composition onto a substrate; exposing a surface of the precursor composition to a first dose of electromagnetic radiation, wherein the first dose has a first property which induces annealing of the precursor composition; exposing the surface of the precursor composition to a second dose of electromagnetic radiation, wherein the second dose has a second property which induces annealing of the precursor composition, wherein the first property is different to the second property. The film produced as a result of the first and second doses of electromagnetic radiation comprises a structure porous to gas.

The organic additive may be a polymer additive, and generally may be a combustible additive. The skilled person will understand organic to mean carbon-based, or a material that contains carbon. For example, the additive may be decomposed by combustion upon exposure of the composition, such that a sintered and annealed MOX material is the result of the exposure.

### Brief Description of the Figures

Some preferred embodiments of the disclosure will now be described by way of example only and with reference to the accompanying drawings, in which:
Figure 1 shows a schematic cross-section of a sensing device with two metal oxide sensing regions under irradiation;
Figure 2 shows an example exposure profile comprising a packet of radiation with a sequence of light pulses as achieved by turning the light source on and off;
Figures 3a and 3b show a plan view and cross sectional schematic, respectively, of a shadow mask method;
Figure 4 shows data containing emission spectra for a lamp driven at three different driving voltages which control intensity and peak of the bandwidth;
Figure 5 shows example absorption spectra for a doped SnO₂ based metal oxide;
Figure 6 is a graph with a comparison of film resistance before and after a single 200ps photo annealing pulse obtained by driving the source lamp at various voltages;
Figure 7 shows cross-sectional scanning electron microscope (SEM) images of electrically annealed and photo-annealed metal oxide films;
Figure 8 shows specific data of resistance profiles of gas sensing devices produced by electrically annealed and photo-annealed during a looped gas test;
Figure 9 shows three examples of simulated volumetric (i.e., bulk) temperatures profiles during photo-annealing, after a metal oxide film is exposed to a packet of radiation with increasing number of pulses;

### Detailed Description of the Preferred Embodiments

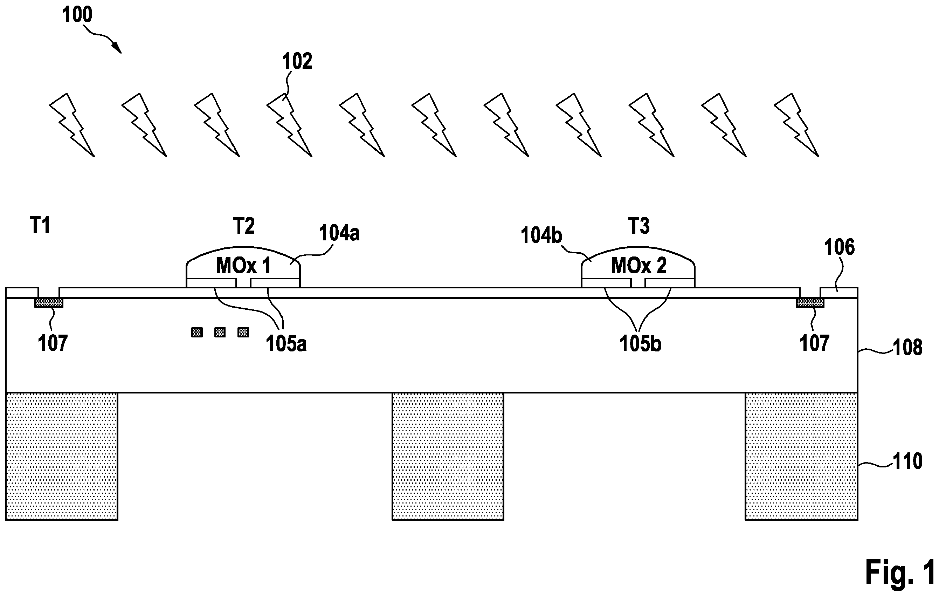

**Figure 1** shows a schematic cross-section view of a sensing device 100, bearing two metal oxide sensing regions 104a, 104b disposed on top of a dielectric/insulating substrate 106, 108, and contact pads 107. The substrate is disposed on further handles 110, which may comprise silicon. The device is shown under irradiation used to anneal the metal oxide (MOX) sensing regions 104a, 104b. The substrate may comprise silicon, which may generally be crystalline silicon. T1, T2 and T3 have to be intended as the characteristic temperatures achieved on the region in correspondence of the contact pads, the metal oxide materials 104a and 104b. It will be understood that the handles 110 are actually back etched substrates forming a cavity portion between two handles or etched substrates 110. The dielectric region 108 over the etched substrate becomes a dielectric membrane, particularly for this disclosure, it will be understood that the dielectric region 108 directly over the etched cavity portion between two handles/substrates 110 forms the dielectric membrane.

The metal oxide areas 104a, 104b are disposed over electrodes 105a and 105b, respectively. The electrodes may be used to sense the presence of certain gases. Therefore, the annealed metal oxide regions 104a, 104b may be porous such that they allow the transport of gas from the environment to the electrodes 105a, 105b. The sensing electrodes 105a, 105b may be interdigitated electrodes (IDE), and may be made of a range of suitable electrode materials, e.g. gold. In this example, the electrodes 105a, 105b are disposed above the dielectric membrane 108. In the same way that two MOX material may be present in each of 104a and 104b, two different electrode configurations may be present in each of 104a and 104b. Alternatively, sensing electrodes may also be present above or below the membrane in contact with the sensing material.

The MOx compositions/film 104a, 104b may define part of a sensing structure. The metal oxide comprise in the sensing structure may comprise a material such as tin oxide, tungsten oxide, zinc oxide, chromium oxide, cerium oxide and indium oxide. The metal oxide material may be pure or doped with other metals. The sensing structure may be a porous layer. The sensing structure may be a gas sensitive layer. The sensing composition forming the sensing structure may be deposited using a technique selected from a group including: screen printing, sputtering, chemical vapour deposition (CVD), atomic layer deposition (ALD), ink-jet, drop coating and flame spray pyrolysis.

The electrodes 105a, 105b of the can be made of titanium nitride (TiN), tungsten, titanium tungsten (TiW), gold or platinum. TiN, TiW and tungsten are complementary metal-oxide-semiconductor (CMOS) usable materials and thus when these materials are used as electrodes 105a, 105b they can be manufactured within the CMOS process. Gold and platinum are not CMOS compatible and thus when these materials are used as the electrodes 105a, 105b are generally made outside the CMOS processing steps using a post-CMOS process.

The irradiation 102 is generally in the UV (for example, 10 nm to 400 nm) to visible range (for example, 380nm to 740nm) of the electromagnetic spectrum. The wavelengths of light comprised in the exposure/irradiation are may be substantially uniform, i.e. comprising substantially a single wavelength. Alternatively, the exposure/photons may comprise photons having a range of wavelengths. A peak intensity of the irradiation spectrum may overlap with a peak absorption of a metal oxide material comprised in the sensing areas 104a, 104b.

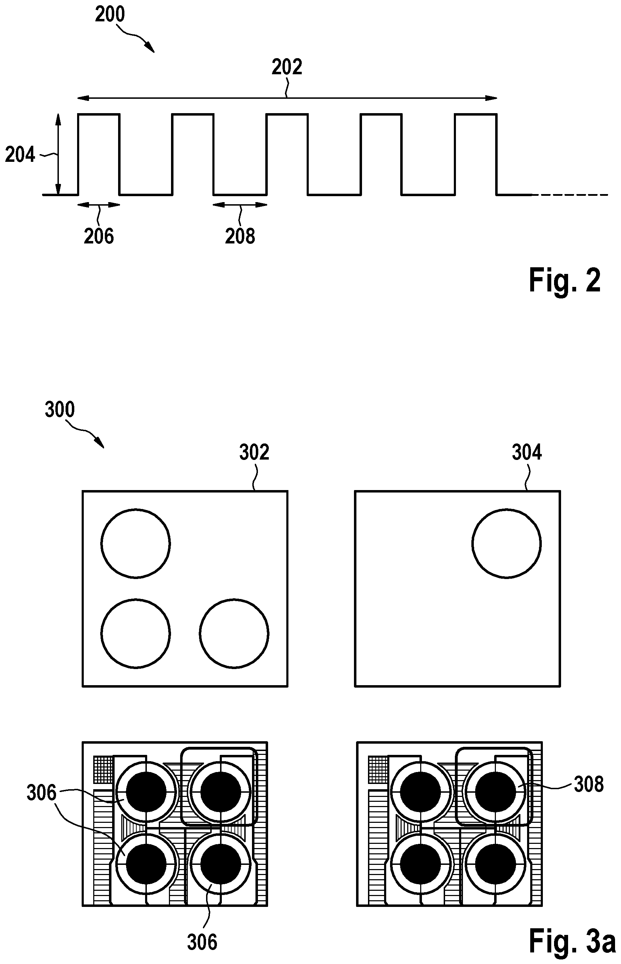

**Figure 2** shows an example exposure profile 200 comprising a packet of radiation. As mentioned, the radiation generally in the UV to visible range of the electromagnetic spectrum. However, in some examples the radiation may comprise photons in the near-IR region.

An exposure, or dose, of radiation may comprise a plurality of individual pulses 206 having a particular pulse length. The plurality of pulses may make up a pulse envelope 202, or packet 202, of radiation. The individual pluses are separated by a corresponding plurality of intervals 208 having an interval length. The pulse has an intensity 204 which can be controlled by the light source voltage for instance.

It is further possible to define a duty cycle, which is the proportion (in units of time) of the total cumulative length of exposure time, compared to the total cumulative time of the overall envelope length (i.e. total annealing time). For example, a pulse length may be 200 µs, with 5 pulses used at a duty cycle of 40 %. This results in an overall envelope 202 annealing time length of 2.5 ms, since a duty cycle of 40% defines that the interval length is 300 µs in this example.

In other example, many more pulses than 5 may be used, and the skilled person will further appreciate that various different patterns of envelopes may be used during an annealing process; for example, to tailor an envelope to a particular metal oxide material.

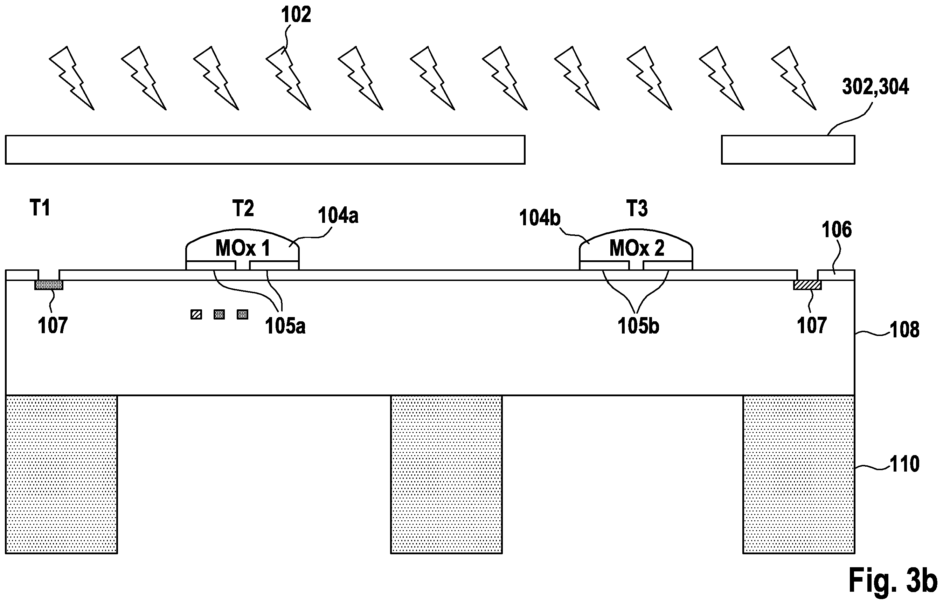

**Figure 3a** shows a plan view of a shadow mask method 300, in which at least one mask 302, 304 may be used to selectively block light/radiation from reached certain metal oxide sensing regions 306, 308. **Figure 3b** similarly shows a cross-sectional schematic of a shadow mask method using a shadow mask 302, 304, in conjunction with the device shown in Figure 1.

For example, a device may comprise two different metal oxide materials, e.g. one MOx material 104a in a first region 306 and another MOX material 104b in a second region 308. Advantageously, when using photo-annealing, each MOX 104a, 104b and region 306, 308 may readily be subjected to a different spectrum of photo-radiation in order to tailor the MOX material to an emission spectrum of light. For example, a spectrum of radiation in a dose may be chosen to maximise the efficiency of the absorption into the material. This method is not possible when using equilibrium annealing processes such as oven annealing processes, since it is almost impossible in that case to exclude the annealing of a particular MOx region.

One way of irradiating and annealing the surface of a device with two different doses comprising two different emission spectra, is to use a photomask 302, 304. For example, masks 302 may be placed over 306 such that a first dose exposes only the three of the metal oxide regions, and omits the upper right MOX composition/region of 306. Another exposure may be performed where mask 304 is used, optionally using a different spectrum of light which may be better suited to annealing the upper right MOX region 308. Thus, in the other exposure, irradiation will only occur onto the upper right MOX region.

Masks may be substantially opaque such that no light or radiation is transmitted through it, except where deliberate gaps spaces are provided as in figure 3.

It will be understood that masks are not necessarily needed in order to provide two (or more) exposures of radiation to a MOX sensors comprising multiple MOX materials. For example, two exposures comprising different wavelengths (e.g. different ranges of electromagnetic radiation) may be directed at a substrate bearing two different sensing regions 306, 308 each having a different MOX composition 104a, 104b. One exposure may be tuned to induce annealing only in the first MOX material 104a, and the other exposure may be tuned (e.g. be chosen to have specific wavelengths of light) specifically to induce annealing only in the other/second MOX materials 104b. In other words, each dose of light/radiation may be substantially better absorbed by only one of the MOX materials, which in turn results in the heating and annealing of only one MOX material at a time. The different exposures comprising different ranges of wavelengths of light may be provided by two different light sources, e.g. two lamps. For example, Ushio Halogen lamps may be used to provide a light source in the Visible to near IR range. Xenon flash lamps may be used to provide exposures of light in the near-UV to visible range.

Additionally, it will be appreciated by the skilled person that any number of different exposures corresponding to said any number of MOX materials may performed. Similarly, this may correspond to having an arbitrary number of different shadow masks. For example, an environmental sensing device may be required to detect 4 gases, wherein 4 different MOX compositions and/or regions are used, thus requiring a third and fourth dose of electromagnetic region specifically directed at annealing each of the third and fourth species of MOX, respectively.

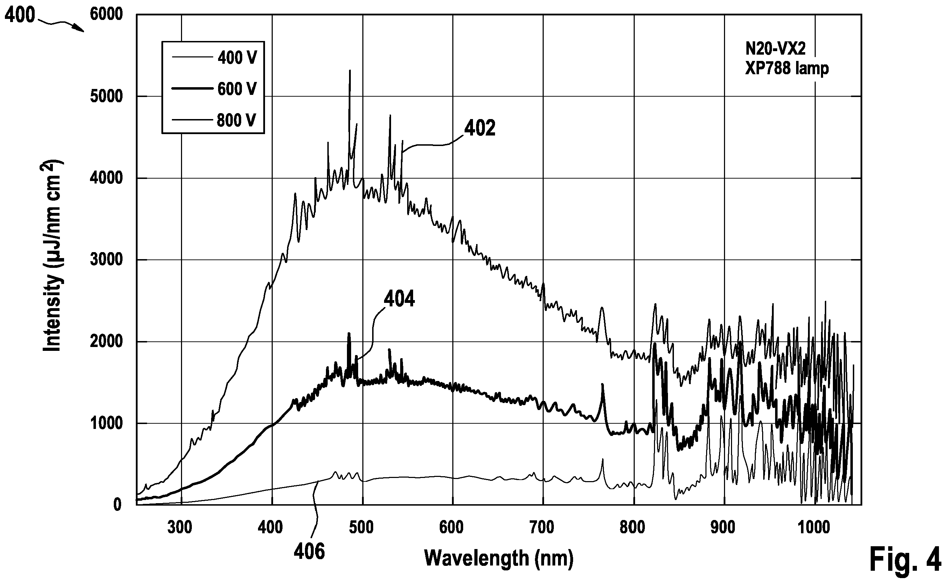

**Figure 4** shows data 400 containing emission spectra for a lamp driven at three different voltages. In this example, photons comprising a range of wavelengths are shown, where a maximum intensity of wavelength is generally seen towards the blue/violet and UV range just below 500 nm. Emission spectrum 402 relates to a lamp driven at 800 V; spectrum 404 relates to 600 V; and spectrum 406 relates to 400 V.

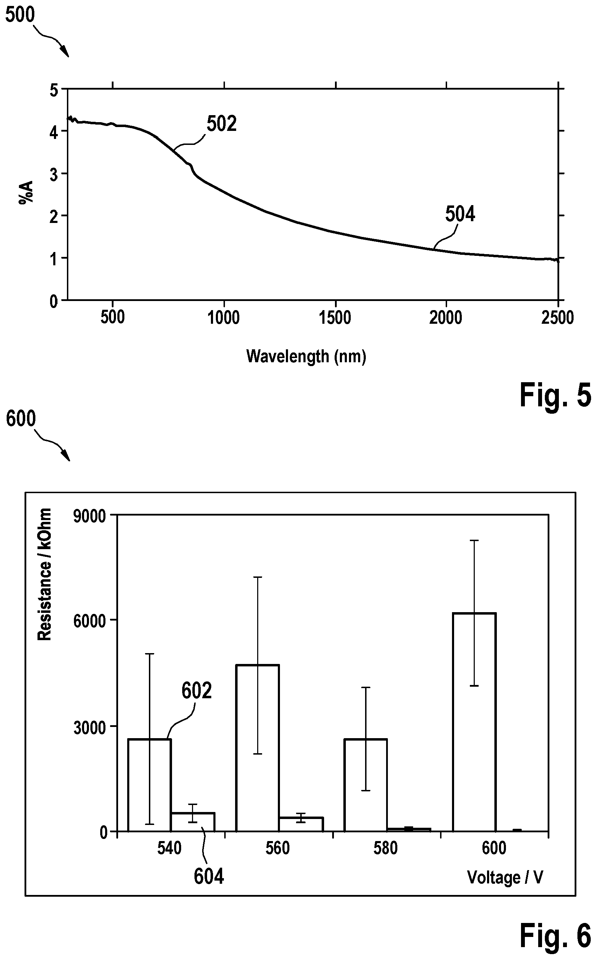

**Figure 5** shows example absorption spectra 500 for a doped SnO₂ based metal oxide. It can be seen that an area of maximum absorbance 502 occurs for this MOX material in the region below 1000 nm, and particularly in the region below 700 nm. Thus, it will be appreciated that an exposure containing light with a spectrum 402, 404, 406 (such as in the Figure 4 graph 400) will be efficiently absorbed into this doped SnO₂ based metal oxide. For example, the doped metal oxide may be a Pd-Pt-SnO₂ MOX material.

Thus, is should be appreciated that, by tuning the emissions spectrum, e.g., by controlling lamp voltages as in 402, 404, 406, or by using a cut-off filter in between the light source and the sample, may result in an effective overlap with the absorption spectra of a MOX material, a highly efficient annealing method may be implemented. In more detail, a very high energy density exposure can be implemented, which in turn allows for very short pulses (below 1 ms) to be used. Therefore, photo-annealing allows for rapid annealing processing of MOX films, and a much higher through-put in manufacture of devices which required annealed MOX films.

An energy density from a photo-annealing method may thus, advantageously, be much greater than an IR-lamp annealing method. For example, a full cycle using an IR lamp annealing method (such as rapid temperature processing, RTP) may produce an energy density of ~ 0.07 kW cm⁻² with pulse length of at least 0.2 s. By contrast, an energy density of a photo-annealing method may be up to about 35 kW cm⁻², where pulse lengths of only about 25 µs - 10 ms may be required. Increasingly efficient annealing is especially achievable by maximising an overlap between an emission spectrum of a lamp and absorption of a MOX material.

The energy density of the infrared lamps is thus much lower (e.g., 0.07 kW/cm²) than for instance the one offered by a photo-annealing lamp, e.g. a xenon lamps (e.g., 35 kW/cm²). In addition, absorption of infrared radiation by metal oxide is lower than absorption of radiation within the visible and UV range. Thus, annealing by IR-lamps affords a less effective method than photo-annealing.

As a result of the very short pulse times achievable by using photo-annealing, and due to the high energy density available, very high annealing temperatures of the MOX surface/composition may be achieved. Moreover, because this high temperature of annealing may be achieved in a short period of time, active substrate cooling is not necessary (as it may be with IR-lamp methods). Thus, the equipment may generally be simpler, and faster, than for IR-lamp or RTP annealing processes. Electrodes 105, for example gold IDE (interdigitated electrodes) may be particularly susceptible to damage due to high temperatures. Therefore, photo-annealing provides a safer means of annealing MOX sensing regions 104a, 104b, because lower temperatures may be maintained in the immediately regions (105, 106, 107, 108) underneath the MOX layer 104a, 104b.

**Figure 6** is a graph with a comparison of film resistance before and after a photo annealing step. A single 200 µs pulse was used to produce the graph with the lamp driven at increasing voltages thus resulting in larger energy density (i.e., intensity) and larger shift towards UV. The lefthand bars 602 correspond to devices before photo-annealing, and the right-hand bars correspond to devices after photo-annealing. It can be seen that the resistance of a MOX film is dramatically reduced after a single photo-annealing pulse.

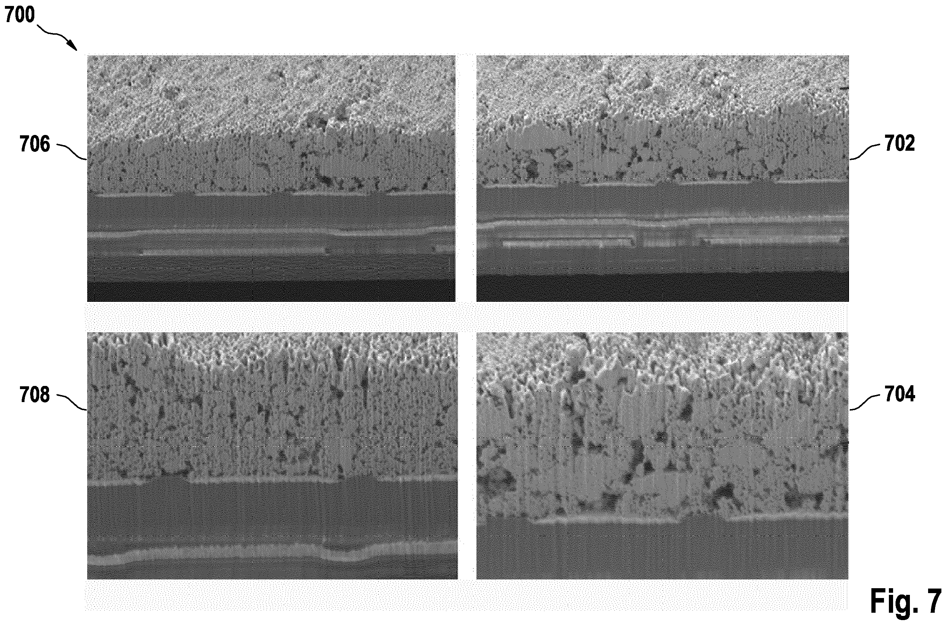

**Figure 7** shows cross-sectional plan view scanning electron microscope (SEM) images 700 of annealed metal oxide films. The lower images correspond to higher resolution images of the upper images.

The lighter layer on the upper surface, with multiples pores of varying sizes, is the annealed MOX film. MOX films 702, 704 of the right hand side correspond to films which have been photo-annealed. MOX films 706, 708 on the left have been annealed using a combination of RTP (i.e. using an IR lamp), and an electrical annealing step.

Generally, an advantage of the high temperatures and rapid heating accessible with photo-annealing, the sintering of the MOX film may be improved during annealing. That is, sintering may be improved relative to annealing using conventional annealing method, for example which may have thermal equilibrium and prolonged heating. The porosity of the MOX film may generally be tuned using photo-annealing. For example, micro-porosity in a post-annealed MOX film may be reduced using photo-annealing. Thus, photo-annealed films 702 and 704 comprise fewer micro-pores than conventionally annealed MOX films 706, 708.

Moreover, due to the improved/reduced properties of micro-porosity, the structure of the MOX film may be advantageously strengthened using Photo-annealing. The reduction in micro-pores may be caused by the rapid annealing, in which materials used in a precursor composition of the MOX film are rapidly decomposed during annealing. Decomposition may comprise formation of gases, e.g. CO₂ and H₂O.

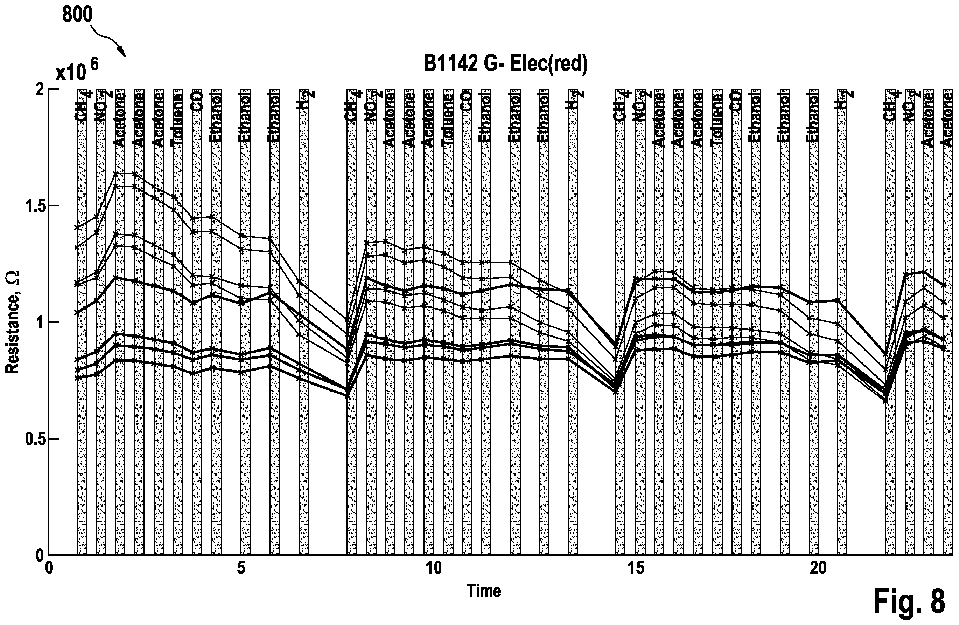

**Figure 8** shows specific data 800 of resistance profiles of gas sensing devices during a looped gas test. The resistance response of a sensing region comprised within the MOX is shown, corresponding to various gases: methane, NO₂, Acetone, toluene, CO, ethanol, and Hydrogen. The gas sequence is repeated over time.

The resistance can be seen to reduce depending on increasing cycle number, for devices (upper lines, 802) which are annealed using conventional electrical and RTP annealing. This overall change, e.g. reduction, in resistance may be defined as 'drift'. However, devices annealed using photo-annealing (805, lower lines) generally show much less drift. Therefore, there is evidence that photo-annealing provides an advantageously stable advice, with greater reliability, and which exhibits less variation with time.

As mentioned, various components underlying the MOX sensors may be sensitive to high temperatures, such as interdigitates electrodes, for example made of gold. Damage of an IDE due to excess heat may cause undesirable 'drift' to occur in a device after successive cycles. Advantageously, use of photo-annealing in a MOX device 100 containing such sensitive electrode 105a, 105b may mitigate potential damage and drift in devices. This is result of the rapid heating of the MOX surface, and corresponding rapid heat dissipation of heat to the surrounding surface.

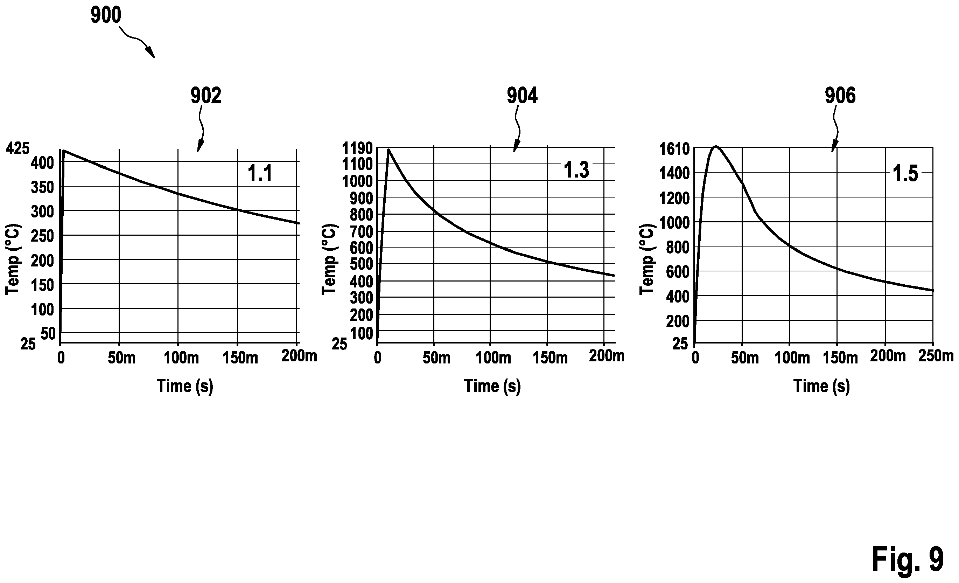

**Figure 9** shows three examples of simulated profiles of the volumetric (bulk) temperatures 900 during photo-annealing, after a metal oxide film has been exposed to a pulse of radiation. Each enveloped was based on a series of pulse of light, with pulse duration of 200 ps, duty cycle 40%, and pulse interval length 300 µs. A voltage of 460 V was used to power the lamp providing the source of light. Further data is tabulated below:

| Figure | Envelope length / ms | Number of pulses | Energy density / mJ cm⁻² | Surface temperature / °C. | Volumetric temperature / °C. |
|---|---|---|---|---|---|
| 902 | 2.5 | 5 | 3.16 | 1030 | 425 |
| 904 | 10 | 20 | 9.57 | 2420 | 1190 |
| 906 | 50 | 100 | 19.4 | 2580 | 1610 |

Thus, it can be seen that very high annealing temperatures may be achieved with only very short pulses. The rapid decay of the temperatures profiles 902, 904, 906 also has the advantage that heat is dissipated very quickly away from the MOX film. Therefore, heating of an adjacent or underlying substrate is minimised, and so no active substrate cooling is needed. Moreover, this is advantageous in examples where the substrate contains heat-sensitive materials. For example, the bulk Aluminium oxidises at above around 380 °C, which may exclude its use in a substrate when conventional annealing techniques are used. However, due to rapid heat dissipation of photo-annealing, aluminium may safely be used in substrates.

As illustrated in Figure 9, and in the SEM images of figure 7, a state of MOX can be reached that is not accessible in an equilibration process (such as oven annealing). For instance, a higher temperature can be achieved using photo-annealing (although for a short time) than using RTP (using pulses of IR radiation and IR-lamps), or oven annealing. In the latter processes MOX temperature is in a thermal equilibrium with the surrounding environment under given operational conditions.

Using light allows further advantages to be achieved in addition to efficient annealing. For example, particular wavelengths of light may be used in order to tune the surface chemistry of a MOX composition, for instance changing the concentration of hydroxyl groups and thus wettability and electrical conductivity of the metal oxide. In addition, UV light may enhance the decomposition of polymer additives by photo-catalysis. For example, light e.g. UV light may induce production of excitons (e.g. electron-hole pairs) in a MOX material. Photo-generated holes may migrate towards the surface reacting, with the polymer additives i.e., oxidizing, and further enhancing the thermal decomposition of these molecules. In other examples oxygen vacancies may be altered in the MOX film, which again may modulate the response of a gas sensing device to certain gases. Generally, it will be appreciated that the versatility of the photo-annealing process in general, an in particular the ability to functionalise a surface of a MOX sensing region, allows to tune a sensor's response to particular gases.

### Index of figure references:

| Figure reference | Corresponding language |
|---|---|
| 100 | Model structure |
| 102 | Photons, irradiation, exposure |
| 104a, 104b | Sensing material, metal oxide film, composition |
| 105a, 104b | Electrodes, sensing electrodes, interdigitated electrodes |
| 106, 108 | Insulating/dielectric material |
| 107 | Contact pads |
| 110 | (Silicon) substrate, handles |
| 200 | Exposure profile, packet |
| 202 | Pulse envelope length |
| 204 | Lamp voltage, pulse intensity |
| 206 | Light pulse length |
| 208 | Pulse interval / duty cycle |
| 300 | Shadow mask method |
| 302, 304 | Shadow mask |
| 306, 308 | Metal oxide films, sensing material |
| 400 | Emission spectra |
| 402, 404, 406 | Voltage dependent emission profiles |
| 500 | Absorption spectrum |
| 502 | High absorbance region, UV region |
| 504 | Low absorbance region, IR region |
| 600 | Annealing comparison |
| 602 | Before photo-annealing |
| 604 | After photo-annealing |
| 700 | Annealing morphologies SEM |
| 702, 704 | Photon-annealing morphology/micro-porosity |
| 706, 708 | RTP + electrical annealing morphology/ micro-porosity |
| 800, 802, 804 | Cycle vs resistance: Comparison of photo-annealing method |
| 900 | Example annealing results |
| 902, 904, 906 | Pulse-dependent annealing temperatures |

The skilled person will understand that in the preceding description and appended claims, positional terms such as 'top', 'above', 'overlap', 'under', 'lateral', etc. are made with reference to conceptual illustrations of a device, such as those showing standard cross-sectional perspectives and those shown in the appended drawings. These terms are used for ease of reference but are not intended to be of limiting nature. These terms are therefore to be understood as referring to a device when in an orientation as shown in the accompanying drawings. Although the disclosure has been described in terms of preferred embodiments as set forth above, it should be understood that these embodiments are illustrative only and that the claims are not limited to those embodiments. Those skilled in the art will be able to make modifications and alternatives in view of the disclosure which are contemplated as falling within the scope of the appended claims. Each feature disclosed or illustrated in the present specification may be incorporated in the disclosure, whether alone or in any appropriate combination with any other feature disclosed or illustrated herein, as long as the resulting combination falls within the scope of the appended claims.

The present application claims priority of the US application 16/414,127.

## Claims

1. A method of annealing a composition to produce a film for a sensing device (100), the composition comprising at least one metal oxide material (104a, 104b), the method comprising:
depositing the composition on one side of a substrate (106, 108);
providing a source of electromagnetic radiation (102) in a proximity to the composition;
exposing a surface of the composition to a first dose of electromagnetic radiation (102), wherein the first dose comprises a first property which induces annealing of the composition;
exposing the surface of the composition to a second dose of electromagnetic radiation (102), wherein the second dose comprises a second property which induces annealing of the composition,
wherein the first property is substantially the same or different to the second property,
wherein the composition comprises a first metal oxide material (104a) and a second metal oxide material (104b),
**characterized in**
**that** the first and second metal oxide materials (104a, 104b) possess different first and second absorption spectra,
wherein the first dose of radiation (102) induces a rate of annealing in the first metal oxide (104a) which is higher relative to a rate of annealing induced in the second metal oxide (104b) by the first dose, and
wherein the second dose of radiation (102) induces a rate of annealing in the second metal oxide (104b) which is higher relative to a rate of annealing induced in the first metal oxide (104a) by the second dose.

2. The method of claim 1, wherein the electromagnetic radiation (102) of the first and second doses comprises electromagnetic radiation in a range of any of: UV, visible, near infra-red, and far infra-red.

3. The method of claim 1, wherein the first and second properties of the first and second doses relate to frequencies of electromagnetic radiation (102).

4. The method of claim 1, wherein the first and second properties of the first and second doses relate to lengths of exposure time.

5. The method of claim 1, wherein at least one of first and second properties of the first and second doses is chosen to functionalise an aspect of chemistry of the surface of composition.

6. The method of claim 1, further comprising choosing the first and second absorption spectra of the first and second doses of radiation (102) to complement the absorption spectra of the first and second metal oxide materials (104a, 104b).

7. The method of claim 1, wherein:
the higher rate of annealing in the first metal oxides (104a) corresponds to a higher temperature only in a local region of the first metal oxides (104a); and
the higher rate of annealing in the second metal oxides (104b) corresponds to a higher temperature only in a local region of the second metal oxides (104b).

8. The method of claim 1, wherein the surface of the composition comprises a first region (306) and a second region (308), wherein the first and second regions (306, 308) are separated.

9. The method of claim 8, further comprising:
during exposing the surface of the composition to the first dose of electromagnetic radiation (102), providing a first mask (302) before the source of electromagnetic radiation (102), wherein the first mask (302) allows transmission of radiation (102) to the first region (306) of the composition.

10. The method of claim 8, further comprising:
during exposing the surface of the composition to the second dose of electromagnetic radiation (102), providing a second mask (304) before the source of electromagnetic radiation (102), wherein the second mask (304) allows transmission of radiation (102) to the second region (308) of the composition.

11. The method of claim 1, further comprising providing either or both of the first dose and second dose of radiation (102) in a plurality of pulses (206), wherein the pulses (206) are interspersed with intervals of non-exposure.

12. The method of claim 1, wherein exposing the surface of the composition to either or both of the first and second doses causes the composition to reach a temperature between 400 and 1500 ° C.

13. The method of claim 1, wherein a total exposure time is less than about 10 ms.

14. The method of claim 1, wherein the composition further comprises a polymer, wherein either or both of the first and second dose causes decomposition of the polymer to a gaseous by-product.

15. The method of claim 1, further comprising providing a second source of electromagnetic radiation (102) in a proximity to the composition, wherein the second source provides the second dose of electromagnetic radiation (102) having the associated second property.

## Patentansprüche

1. Ein Verfahren zum Tempern einer Zusammensetzung zur Herstellung eines Films für ein Sensorbauelement (100), wobei die Zusammensetzung mindestens ein Metalloxidmaterial (104a, 104b) umfasst, wobei das Verfahren umfasst:
Abscheiden der Zusammensetzung auf einer Seite eines Substrats (106, 108);
Bereitstellung einer Quelle für elektromagnetische Strahlung (102) in der Nähe der Zusammensetzung;
Aussetzen einer Oberfläche der Zusammensetzung einer ersten Dosis elektromagnetischer Strahlung (102), wobei die erste Dosis eine erste Eigenschaft umfasst, die ein Tempern der Zusammensetzung induziert;
Aussetzen der Oberfläche der Zusammensetzung einer zweiten Dosis elektromagnetischer Strahlung (102), wobei die zweite Dosis eine zweite Eigenschaft umfasst, die ein Tempern der Zusammensetzung bewirkt,
wobei die erste Eigenschaft im Wesentlichen gleich oder verschieden von der zweiten Eigenschaft ist,
wobei die Zusammensetzung ein erstes Metalloxidmaterial (104a) und ein zweites Metalloxidmaterial (104b) umfasst,
**gekennzeichnet dadurch**
**dass** die ersten und zweiten Metalloxidmaterialien (104a, 104b) unterschiedliche erste und zweite Absorptionsspektren aufweisen,
wobei die erste Strahlungsdosis (102) eine Temperrate in dem ersten Metalloxid (104a) induziert, die höher ist als eine durch die erste Dosis induzierte Temperrate in dem zweiten Metalloxid (104b), und
wobei die zweite Strahlungsdosis (102) in dem zweiten Metalloxid (104b) eine Temperrate induziert, die höher ist als eine durch die zweite Dosis in dem ersten Metalloxid (104a) induzierte Temperrate.

2. Das Verfahren gemäß Anspruch 1, wobei die elektromagnetische Strahlung (102) der ersten und zweiten Dosis elektromagnetische Strahlung aus einem der folgenden Bereiche umfasst: UV, sichtbar, Nahinfrarot und Ferninfrarot.

3. Das Verfahren gemäß Anspruch 1, wobei sich die ersten und zweiten Eigenschaften der ersten und zweiten Dosis auf die Frequenzen der elektromagnetischen Strahlung (102) beziehen.

4. Das Verfahren gemäß Anspruch 1, wobei sich die ersten und zweiten Eigenschaften der ersten und zweiten Dosis auf die Länge der Expositionszeit beziehen.

5. Das Verfahren gemäß Anspruch 1, wobei mindestens eine der ersten und zweiten Eigenschaften der ersten und zweiten Dosis ausgewählt wird, um einen Aspekt der Chemie der Oberfläche der Zusammensetzung zu funktionalisieren.

6. Das Verfahren gemäß Anspruch 1, ferner umfassend das Auswählen des ersten und zweiten Absorptionsspektrums der ersten und zweiten Strahlungsdosis (102), um die Absorptionsspektren des ersten und zweiten Metalloxidmaterials (104a, 104b) zu ergänzen.

7. Das Verfahren gemäß Anspruch 1, wobei:
die höhere Temperrate in den ersten Metalloxiden (104a) einer höheren Temperatur nur in einem lokalen Bereich der ersten Metalloxide (104a) entspricht; und
die höhere Temperrate in den zweiten Metalloxiden (104b) einer höheren Temperatur nur in einem lokalen Bereich der zweiten Metalloxide (104b) entspricht.

8. Das Verfahren gemäß Anspruch 1, wobei die Oberfläche der Zusammensetzung einen ersten Bereich (306) und einen zweiten Bereich (308) umfasst, wobei der erste und der zweite Bereich (306, 308) getrennt sind.

9. Das Verfahren gemäß Anspruch 8 ferner umfassend:
Bereitstellen einer ersten Maske (302) vor der Quelle der elektromagnetischen Strahlung (102), während die Oberfläche der Zusammensetzung der ersten Dosis elektromagnetischer Strahlung (102) ausgesetzt wird, wobei die erste Maske (302) die Transmission der Strahlung (102) auf den ersten Bereich (306) der Zusammensetzung ermöglicht.

10. Das Verfahren gemäß Anspruch 8 ferner umfassend:
Bereitstellen einer zweiten Maske (304) vor der Quelle der elektromagnetischen Strahlung (102), während die Oberfläche der Zusammensetzung der zweiten Dosis elektromagnetischer Strahlung (102) ausgesetzt wird, wobei die zweite Maske (304) die Transmission der Strahlung (102) auf den zweiten Bereich (308) der Zusammensetzung ermöglicht.

11. Das Verfahren gemäß Anspruch 1, ferner umfassend das Bereitstellen der ersten Strahlungsdosis oder der zweiten Strahlungsdosis (102) oder beider in einer Vielzahl von Impulsen (206), wobei die Impulse (206) mit Intervallen von Nichtexposition durchsetzt sind.

12. Das Verfahren gemäß Anspruch 1, wobei das Aussetzen der Oberfläche der Zusammensetzung einer oder beiden der ersten und zweiten Dosen bewirkt, dass die Zusammensetzung eine Temperatur zwischen 400 und 1500° C erreicht.

13. Das Verfahren gemäß Anspruch 1, wobei eine gesamte Expositionszeit weniger als etwa 10 ms beträgt.

14. Das Verfahren gemäß Anspruch 1, wobei die Zusammensetzung ferner ein Polymer umfasst, wobei entweder die erste oder die zweite Dosis oder beide die Zersetzung des Polymers zu einem gasförmigen Nebenprodukt bewirken.

15. Das Verfahren gemäß Anspruch 1, ferner umfassend ein Bereitstellen einer zweiten Quelle elektromagnetischer Strahlung (102) in der Nähe der Zusammensetzung, wobei die zweite Quelle die zweite Dosis elektromagnetischer Strahlung (102) mit der zugehörigen zweiten Eigenschaft bereitstellt.

## Revendications

1. Une méthode de recuit d'une composition pour produire un film pour un dispositif de détection (100), la composition comprenant au moins un matériau d'oxyde métallique (104a, 104b), la méthode comprenant:
dépôt de la composition sur une face d'un substrat (106, 108) ;
fournir une source de rayonnement électromagnétique (102) à proximité de la composition;
exposer une surface de la composition à une première dose de rayonnement électromagnétique (102), la première dose comprenant une première propriété qui induit le recuit de la composition;
exposer la surface de la composition à une deuxième dose de rayonnement électromagnétique (102), la deuxième dose comprenant une deuxième propriété qui induit le recuit de la composition,
dans lequel la première propriété est essentiellement la même ou différente de la deuxième propriété,
dans laquelle la composition comprend un premier matériau d'oxyde métallique (104a) et un second matériau d'oxyde métallique (104b),
caractérisé en
que le premier et le second matériau d'oxyde métallique (104a, 104b) possèdent un premier et un second spectre d'absorption différents,
dans lequel la première dose de rayonnement (102) induit un taux de recuit dans le premier oxyde métallique (104a) qui est supérieur à un taux de recuit induit dans le second oxyde métallique (104b) par la première dose, et
dans lequel la seconde dose de rayonnement (102) induit un taux de recuit dans le second oxyde métallique (104b) qui est supérieur à un taux de recuit induit dans le premier oxyde métallique (104a) par la seconde dose.

2. La méthode de la revendication 1, dans laquelle le rayonnement électromagnétique (102) de la première et de la deuxième dose comprend un rayonnement électromagnétique dans une gamme de: UV, visible, proche infrarouge et infrarouge lointain.

3. La méthode de la revendication 1, dans laquelle les première et deuxième propriétés des première et deuxième doses se rapportent à des fréquences de rayonnement électromagnétique (102).

4. La méthode de la revendication 1, dans laquelle la première et la deuxième propriétés de la première et de la deuxième dose se rapportent à des durées d'exposition.

5. La méthode de la revendication 1, dans laquelle au moins l'une des premières et secondes propriétés des premières et secondes doses est choisie pour fonctionnaliser un aspect de la chimie de la surface de la composition.

6. La méthode de la revendication 1, comprenant en outre le choix des premier et deuxième spectres d'absorption des première et deuxième doses de rayonnement (102) pour compléter les spectres d'absorption des premier et deuxième matériaux d'oxyde métallique (104a, 104b).

7. La méthode de la revendication 1, dans laquelle:
le taux de recuit plus élevé dans les premiers oxydes métalliques (104a) correspond à une température plus élevée uniquement dans une région locale des premiers oxydes métalliques (104a); et
le taux de recuit plus élevé dans les seconds oxydes métalliques (104b) correspond à une température plus élevée uniquement dans une région locale des seconds oxydes métalliques (104b).

8. La méthode de la revendication 1, dans laquelle la surface de la composition comprend une première région (306) et une deuxième région (308), la première et la deuxième région (306, 308) étant séparées.

9. La méthode de la revendication 8, comprenant en outre: pendant l'exposition de la surface de la composition à la première dose de rayonnement électromagnétique (102), fournir un premier masque (302) devant la source de rayonnement électromagnétique (102), dans lequel le premier masque (302) permet la transmission du rayonnement (102) à la première région (306) de la composition.

10. La méthode de la revendication 8, comprenant en outre: pendant l'exposition de la surface de la composition à la deuxième dose de rayonnement électromagnétique (102), fournir un deuxième masque (304) devant la source de rayonnement électromagnétique (102), dans lequel le deuxième masque (304) permet la transmission du rayonnement (102) à la deuxième région (308) de la composition.

11. La méthode de la revendication 1, comprenant en outre fournir la première dose et la seconde dose de rayonnement (102), ou des deux, en plusieurs impulsions (206), les impulsions (206) étant entrecoupées d'intervalles de non-exposition.

12. La méthode de la revendication 1, dans laquelle l'exposition de la surface de la composition à la première ou à la deuxième dose, ou aux deux, permet à la composition d'atteindre une température comprise entre 400 et 1500° C.

13. La méthode de la revendication 1, dans laquelle le temps d'exposition total est inférieur à environ 10 ms.

14. La méthode de la revendication 1, dans laquelle la composition comprend en outre un polymère, l'une ou l'autre ou les deux doses provoquant la décomposition du polymère en un sous-produit gazeux.

15. La méthode de la revendication 1, comprenant en outre fournir d'une deuxième source de rayonnement électromagnétique (102) à proximité de la composition, dans laquelle la deuxième source fournit la deuxième dose de rayonnement électromagnétique (102) ayant la deuxième propriété associée.
